# FASCICULE DE BREVET EUROPEEN

(11) **EP 0 613 241 B1**
(45) Date de publication et mention de la délivrance du brevet: **21.10.1998**
(21) Numéro de dépôt: 94410010.6
(22) Date de dépôt: 23.02.1994
(51) Int. Cl.: H03F 3/45, H03F 3/30

(54) **Dispositif de régulation de la tension de mode commun en sortie d'un amplificateur équilibré**
Ausgangsgleichtaktspannungssteuerungseinrichtung für ausbalancierten Verstärker
Output common-mode voltage control device of a balanced amplifier

(30) Priorité: 26.02.1993 FR 9302616
(43) Date de publication de la demande: 31.08.1994
(73) Titulaire: SGS-THOMSON MICROELECTRONICS S.A., 94250 Gentilly (FR)
(72) Inventeur: Mazoyer, Yves, F-38100 Grenoble (FR); Fensch, Thierry, F-38000 Grenoble (FR)
(74) Mandataire: de Beaumont, Michel

(56) Documents cités:
- EP-A- 0 234 806
- DE-B- 1 238 961
- US-A- 3 444 476
- IEEE INTERNATIONAL SOLID STATE CIRCUITS CONFERENCE, vol.34, Février 1991, NEW YORK US pages 278 - 329 G. NICOLLINI ET AL 'A -78DB THD 100 OHM DIFFERENTIAL DRIVER FOR ISDN APPLICATIONS'

## Description

La présente invention telle qu'elle est définie dans les revendications concerne les amplificateurs différentiels équilibrés, c'est-à-dire les amplificateurs à deux sorties différentielles fournissant respectivement un premier signal et un deuxième signal en opposition de phase.

L'invention concerne plus particulièrement un dispositif de régulation de la tension de mode commun en sortie d'un tel amplificateur. Le document EP-A-0 234 806 divulgue un tel amplificateur.

Les amplificateurs équilibrés sont utilisés lorsque l'on a besoin d'une grande variation de tension de sortie (dynamique de sortie) alors qu'on ne dispose que d'une faible tension d'alimentation.

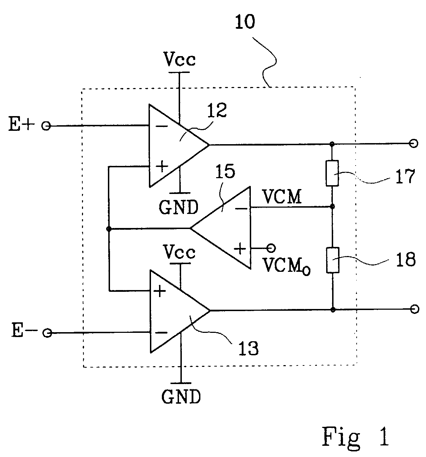

La figure 1 représente un amplificateur équilibré 10. Cet amplificateur comprend deux amplificateurs différentiels 12 et 13 alimentés chacun par un potentiel haut Vcc et un potentiel bas GND. Les sorties des amplificateurs 12 et 13 constituent les sorties différentielles de l'amplificateur équilibré 10. Les entrées inverseuses des amplificateurs différentiels 12 et 13 sont reliées à des bornes d'entrée différentielles, respectivement E+ et E-.

La tension de mode commun VCM en sortie de l'amplificateur 10, c'est-à-dire la moyenne des tensions de sortie des amplificateurs 12 et 13, est susceptible de varier. Une première cause de variation est la variation de la tension de mode commun en entrée, ce qui se produit, par exemple, si les tensions appliquées sur les bornes E+ et E- ne sont pas symétriques par rapport à une tension de référence fixe. Une deuxième cause, systématique, est la dispersion des caractéristiques entre les transistors de type N et les transistors de type P constituant l'amplificateur 10.

Une variation trop importante de la tension VCM par rapport à une valeur de référence, par exemple (Vcc+GND)/2, peut entraîner l'écrêtage du signal de sortie de l'amplificateur 10, notamment si l'amplitude du signal de sortie est proche de sa valeur maximale. Il est donc néoessaire de réguler la tension de mode commun en sortie, VCM.

Un dispositif de régulation classique de la tension de mode commun en sortie comprend un amplificateur différentiel de correction 15 dont la sortie est reliée aux entrées non inverseuses des amplificateurs 12 et 13. L'entrée inverseuse de l'amplificateur 15 reçoit la moyenne, VCM, des tensions de sortie de l'amplificateur 10 par l'intermédiaire d'un pont de résistances 17 et 18 de même valeur. L'entrée non-inverseuse de l'amplificateur 15 reçoit une tension de référence VCM_{O} sur laquelle on souhaite réguler la tension de mode commun VCM.

Avec cette configuration, les erreurs de mode commun, c'est-à-dire les écarts entre la tension VCM et la tension VCM_{O}, sont inversement proportionnelles au gain de l'amplificateur de correction 15. Ainsi, les erreurs seront minimisées si ce gain est très grand.

En pratique, principalement pour des raisons de stabilité et de rapidité de la régulation, l'amplificateur 15 est formé d'un seul étage différentiel.

Pour limiter la consommation de cet étage, son courant de polarisation est choisi faible, ce qui a pour inconvénient de limiter la dynamique de correction de l'erreur de mode commun.

En effet, un étage différentiel fonctionne de manière linéaire si sa tension d'entrée est de faible amplitude. Si la tension d'entrée devient trop importante, l'étage différentiel sature et son gain chute considérablement, ce qui a pour inconvénient que des erreurs de mode commun trop importantes ne peuvent être corrigées convenablement. Le point de saturation d'un étage différentiel est aussi déterminé par le courant de polarisation de l'étage. Comme le courant de polarisation de l'étage est choisi faible, l'étage sature rapidement.

Un objet de la présente invention est de prévoir un dispositif de régulation de la tension de mode commun du type précédemment décrit, mais ayant un étage différentiel de correction présentant une dynamique de correction élevée tout en consommant peu en moyenne.

Un autre objet de la présente invention est de prévoir un tel dispositif de régulation, dans lequel l'étage différentiel ne risque pas de saturer.

Un autre objet de la présente invention est de prévoir un tel dispositif de régulation qui soit particulièrement simple.

La présente invention est basée sur l'observation du fait que les erreurs de mode commun varient le plus souvent en phase (ou en opposition de phase) avec le courant de sortie de l'amplificateur 10. Pour atteindre les objets susmentionnés, l'invention prévoit un dispositif de régulation dans lequel le courant de polarisation de l'étage différentiel de correction est ajusté proportionnellement au courant de sortie de l'amplificateur.

Avec un tel dispositif, le courant de polarisation de l'étage de correction reste faible en l'absence de signal en sortie de l'amplificateur, mais le courant de polarisation instantané devient important en présence d'un signal de forte amplitude, ce qui permet de corriger une erreur de mode commun avec une même efficacité si elle apparaît en présence d'un signal de forte amplitude, que si elle apparaît en présence d'un signal de faible amplitude. En outre, comme le courant de polarisation de l'étage de correction suit l'évolution de sa tension d'entrée (l'erreur de mode commun), cet étage ne risque pas de saturer.

Une réalisation particulière de ce dispositif à l'aide de miroirs de courant permet une simplification notable de celui-ci.

La présente invention vise plus particulièrement un dispositif de régulation de la tension de mode commun en sortie d'un amplificateur équilibré à deux sorties différentielles, comprenant un étage différentiel fournissant un signal de correction de la tension de mode commun correspondant à l'écart entre la moyenne des tensions sur les sorties différentielles et une tension de référence, et un générateur de courant fixant le courant de polarisation de l'étage différentiel. Selon l'invention, le générateur de courant est un générateur commandé par le courant de sortie de l'amplificateur équilibré.

Selon un mode de réalisation de la présente invention, l'amplificateur équilibré inclut deux étages de sortie comprenant chacun deux miroirs de courant de polarité opposée dont les sorties sont reliées ensemble, et l'étage différentiel fournit un courant de correction superposé, avec un signe approprié, au courant d'entrée d'un premier desdits deux miroirs.

Selon un mode de réalisation de la présente invention, le générateur de courant fixant le courant de polarisation de l'étage différentiel comprend un miroir de courant recopiant, à un facteur multiplicatif près, le courant de sortie du premier miroir.

Selon un mode de réalisation de la présente invention, l'étage différentiel comprend une branche de sortie reliée à l'entrée d'un miroir de courant dont la sortie est reliée en parallèle sur l'entrée du premier miroir de courant.

Selon un mode de réalisation de la présente invention, le miroir de courant fournissant le courant de polarisation à l'étage différentiel est commandé par une deuxième sortie du premier miroir de courant, la première sortie de ce premier miroir étant celle qui est reliée à la sortie de l'autre des deux miroirs de courant de l'étage de sortie.

Ces objets, caractéristiques et avantages ainsi que d'autres de la présente invention seront exposés en détail dans la description suivante de modes de réalisation particuliers faite en relation avec les figures jointes parmi lesquelles :
la figure 1, précédemment décrite, représente schématiquement un amplificateur équilibré muni d'un dispositif classique de régulation de la tension de mode commun en sortie ;
la figure 2 représente une demi-vue d'un mode de réalisation d'un dispositif de régulation selon la présente invention inséré dans un étage de sortie classique d'un amplificateur ; et
la figure 3 représente une demi-vue d'un autre mode de réalisation de dispositif de régulation selon la présente invention.

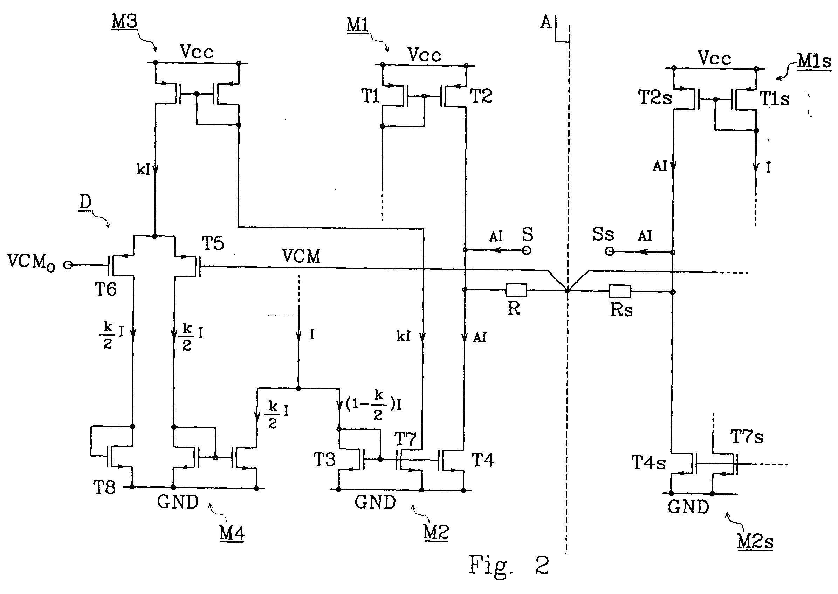

Un dispositif de régulation selon l'invention s'adapte de manière particulièrement aisée à un type particulier d'étage de sortie d'un amplificateur, apparaissant dans la figure 2.

La figure 2 montre, à gauche d'un axe de symétrie A, un premier étage de sortie fournissant une première sortie d'un amplificateur équilibré. La deuxième sortie de l'amplificateur équilibré est fournie par un étage symétrique au premier par rapport à l'axe A. Chaque élément décrit ci-après d'un côté de l'axe A a un symétrique, non décrit, de l'autre côté de l'axe A que l'on désigne par une même référence affectée de l'indice "s".

Le premier étage de sortie comprend un miroir de courant M1 relié à un potentiel haut Vcc et un miroir de courant M2 relié à un potentiel bas GND. Ci-après, un miroir relié à un potentiel haut est appelé miroir de polarité positive, et un miroir relié à un potentiel bas est appelé miroir de polarité négative. Le miroir de polarité positive M1 comprend un transistor d'entrée T1, MOS à canal P, dont la source est reliée au potentiel Vcc et dont la grille et le drain sont reliés ensemble. Le drain du transistor T1 constitue l'entrée du miroir M1. Le miroir M1 comprend un transistor de sortie T2, MOS à canal P, dont la source est reliée au potentiel Vcc et la grille à la grille du transistor T1. Le drain du transistor T2 constitue la sortie du miroir M1. Un miroir de courant de polarité négative a la même configuration que le miroir de polarité positive M1 qui vient d'être décrit, sauf que ses transitors sont à canal N et que les sources de ces transistors sont reliées au potentiel bas GND. Le miroir M2 comprend un transistor d'entrée T3, MOS à canal N, et un premier transistor de sortie T4, MOS à canal N. Les sorties des miroirs M1 et M2 (drains des transistors T2 et T4) sont reliées à une borne de sortie S de l'amplificateur équilibré.

Pour injecter un courant dans un premier sens dans une charge reliée entre les bornes de sortie S et Ss, un étage de commande classique, non représenté, fournit aux entrées des miroirs M1 et M2s des courants de sens opposés. Pour injecter un courant AI de deuxième sens dans la charge, des courants I de sens opposés sont fournis, comme cela est représenté, aux entrées des miroirs Mls et M2.

Un pont de résistances R, Rs de même valeur est disposé entre les bornes de sortie S et Ss. Au point de connexion entre les résistances R et Rs, on recueille la tension VCM de mode commun de sortie de l'amplificateur. Cette tension VCM est appliquée sur la grille d'un premier transistor T5 d'un étage différentiel D. Un deuxième transistor T6 de l'étage différentiel, dont la source est reliée à la source du transistor T5, reçoit sur sa grille une tension de référence constante VCMO qui est la tension de mode commun que l'on veut obtenir en sortie de l'amplificateur. Dans l'exemple de la figure 2, les transistors T5 et T6 sont des transistors MOS à canal P.

Selon l'invention, le miroir M2 comprend un deuxième transistor de sortie T7, à grille et source reliées respectivement à la grille et à la source du transistor T4, dont le courant de drain kI constitue le courant de polarisation de l'étage différentiel D. Pour cela, les sources des transistors T5 et T6 sont reliées à la sortie d'un miroir M3 de polarité positive recevant en entrée le courant de drain du transistor T7. En outre, le courant d'entrée I du miroir M2 est partiellement dérivé par la sortie d'un miroir de courant M4 de polarité négative dont l'entrée reçoit le courant de drain du transistor T5 de l'étage différentiel D.

Avec cette configuration, si la tension de mode commun VCM varie, par exemple augmente, par rapport à la tension de référence VCM₀, le courant de drain du transistor T5 diminue ainsi que le courant dérivé par la sortie du miroir M4, ce qui augmente le courant d'entrée du miroir M2. En conséquence, le transistor T4 de sortie du miroir M2 devient plus passant, ce qui a pour résultat d'abaisser la tension sur la borne P, et donc d'abaisser la tension de mode commun VCM.

Le courant de drain du transistor T7 étant proportionnel au courant de drain du transistor T4 (le courant de sortie AI), le courant de polarisation de l'étage différentiel D est proportionnel au courant de sortie AI. Ainsi, l'étage différentiel D ne risque pas de saturer, c'est-à-dire que tout le courant de polarisation kI ne risque plus de passer dans un seul des transistors T5 et T6 lorsque l'écart entre les tensions VCM et VCM₀ devient important.

En outre, le courant de polarisation kI de l'étage D fixe l'amplitude du domaine linéaire de cet étage, c'est-à-dire l'amplitude de variation du courant de drain du transistor T5 par rapport à l'amplitude de variation de l'erreur de mode commun VCM-VCM₀. Pour un étage à transistors MOS, l'amplitude du domaine linéaire est proportionnelle au courant de polarisation. Ainsi, plus le courant de sortie de l'amplificateur est important, c'est-à-dire plus l'amplitude de l'erreur de mode commun risque d'être importante, plus la compensation de cette erreur de mode commun devient efficace.

Le symétrique, non représenté, de l'étage différentiel D agit de manière identique sur le miroir M2s lorsque les miroirs M1 et M2s sont commandés pour injecter un courant -AI de sens opposé dans la charge.

La consommation d'un dispositif de régulation selon l'invention est particulièrement faible. En l'absence de signal de sortie, le courant de polarisation de l'étage D et de son symétrique est nul. Lorsqu'un signal de sortie est présent, l'étage D reçoit un courant de polarisation seulement lors d'alternances paires du signal de sortie (lorsque les miroirs M1s et M2 sont commandés), et l'étage différentiel symétrique reçoit un courant de polarisation seulement lors des alternances impaires (lorsque les miroirs M1 et M2s sont commandés). En outre, le courant de polarisation moyen d'un étage est bien inférieur à son courant maximal.

Bien entendu, les surfaces des transistors des miroirs sont choisies pour ajuster adéquatement les gains des miroirs, à savoir un gain A des miroirs M1 et Mls, un gain A/(1-k/2) entre les transistors T4 et T3 du miroir M2 et entre les transistors symétriques du miroir M2s, et un gain k/(1-k/2) entre les transistors T7 et T3 du miroir M2 et entre les transistors symétriques du miroir M2s. Les valeurs A et k pourront être choisies par l'homme du métier pour adapter l'amplificateur équilibré selon l'invention à ses besoins.

Le drain du transistor T6 est relié au potentiel GND par l'intermédiaire d'une charge présentant les mêmes caractéristiques que l'entrée du miroir M4 pour des raisons de symétrie. Cette charge est, par exemple, un transistor MOS T8 à canal N dont la source est reliée au potentiel GND et dont le drain et la grille sont reliées au drain du transistor T6.

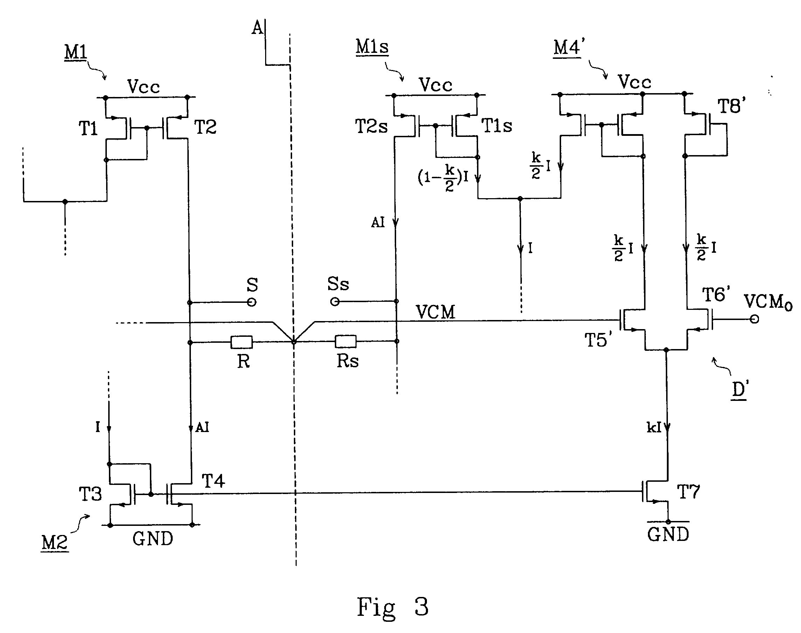

La figure 3 représente un autre mode de réalisation du dispositif de régulation de tension de mode commun selon l'invention. Dans cette figure, des éléments similaires à ceux de la figure 2 sont désignés par des mêmes références. Dans le circuit de la figure 3, on retrouve un étage différentiel D' dont le courant de polarisation est fixé directement par le courant de drain du transistor T7 du miroir M2. L'étage D' comprend des transistors MOS à canal N T5' et T6' recevant respectivement sur leur grille la tension VCM et la tension VCM₀. Le drain du transistor T6' est relié au potentiel Vcc par l'intermédiaire d'un transistor de charge T8' et le courant de drain du transistor T5' est dérivé du courant de commande I du miroir Mls par l'intermédiaire d'un miroir de courant M4' de polarité positive. Des éléments, non représentés, symétriques à ceux que l'on vient de décrire agissent sur le miroir M1.

Le circuit de la figure 3 est théoriquement équivalent au circuit de la figure 2 et permet d'économiser le miroir M3 de la figure 2. Toutefois, en réalité, le circuit de la figure 2 est plus efficace, car on y mesure le courant de sortie (par le transistor T7) au niveau du même miroir de courant, M2, que l'on pilote par l'étage différentiel D.

Les modes de réalisation décrits du dispositif de régulation de tension de mode commun sont de complexité équivalente ou même moindre que celle des dispositifs de régulation classiques.

Bien que l'on ait décrit des modes de réalisation particulièrement avantageux agissant au niveau des étages de sortie de l'amplificateur, la présente invention s'applique également à des circuits dont l'étage de correction agit au niveau de l'entrée de l'amplificateur.

De nombreuses variantes et modifications de la présente invention apparaîtront à l'homme du métier qui peut, par exemple, intervertir les polarités des transistors ou bien choisir des transistors bipolaires.

## Revendications

1. Dispositif de régulation de la tension de mode commun en sortie d'un amplificateur équilibré à deux sorties différentielles (S, Ss), comprenant un étage différentiel (D) fournissant un signal de correction de ladite tension de mode commun correspondant à l'écart entre la moyenne (VCM) des tensions sur les sorties différentielles et une tension de référence (VCM₀), et un générateur de courant fixant le courant de polarisation de l'étage de correction différentiel (D), caractérisé en ce que le générateur de courant est un générateur (M3) commandé par le seul courant de sortie de l'amplificateur équilibré.

2. Dispositif de régulation selon la revendication 1, caractérisé en ce que l'amplificateur équilibré inclut deux étages de sortie comprenant chacun deux miroirs de courant de polarité opposée (M1, M2) dont les sorties sont reliées ensemble, et en ce que ledit étage différentiel (D) fournit un courant de correction superposé, avec un signe approprié, au courant d'entrée d'un premier (M2) desdits deux miroirs.

3. Dispositif de régulation selon la revendication 2, caractérisé en ce que le générateur de courant fixant le courant de polarisation dudit étage différentiel (D) comprend un miroir de courant (M3) recopiant, à un facteur multiplicatif (k) près, le courant de sortie dudit premier miroir (M2).

4. Dispositif de régulation selon la revendication 2, caractérisé en ce que l'étage différentiel (D) comprend une branche de sortie reliée à l'entrée d'un miroir de courant (M4) dont la sortie est reliée en parallèle sur l'entrée du premier miroir de courant (M2).

5. Dispositif de régulation selon la revendication 3, caractérisé en ce que le miroir de courant (M3) fournissant le courant de polarisation à l'étage différentiel (D) est commandé par une deuxième sortie (T7) du premier miroir de courant (M2), la première sortie (T4) de ce premier miroir étant celle qui est reliée à la sortie de l'autre (M1) desdits deux miroirs de courant de l'étage de sortie.

## Patentansprüche

1. Einrichtung zum Regeln der Gleichtaktspannung am Ausgang eines Gegentaktverstärkers mit zwei differentiellen Ausgängen (S, Ss), mit einer Differentialstufe (D), die ein Korrektursignal der Gleichtaktspannung entsprechend der Abweichung zwischen dem Mittelwert (VCM) der Spannungen an den differentiellen Ausgängen und einer Referenzspannung (VCM₀) liefert, und mit einem Stromgenerator, der den Polarisationsstrom der Differentialkorrekturstufe (D) festsetzt, dadurch gekennzeichnet, dass der Stromgenerator ein Generator (M3) ist, der durch den einzigen Ausgangsstrom des Gegentaktverstärkers gesteuert ist.

2. Regeleinrichtung nach Anspruch 1, dadurch gekennzeichnet, dass der Gegentaktverstärker zwei Ausgangsstufen aufweist, die jeweils zwei Stromspiegelschaltungen mit entgegengesetzter Polarität (M1, M2) aufweisen, deren Ausgänge miteinander verbunden sind, und dass die Differentialstufe (D) einen Korrekturstrom abgibt, der, mit geeignetem Vorzeichen, dem Eingangsstrom einer ersten (M2) der beiden Spiegelschaltungen überlagert ist.

3. Regeleinrichtung nach Anspruch 2, dadurch gekennzeichnet, dass der den Polarisationsstrom der Differentialstufe (D) festlegende Stromgenerator eine Stromspiegelschaltung (M3) aufweist, die bis auf einen multiplikativen Faktor (k) den Ausgangsstrom der ersten Spiegelschaltung (M2) kopiert.

4. Regeleinrichtung nach Anspruch 2, dadurch gekennzeichnet, dass die Differentialstufe (D) einen Ausgangszweig aufweist, der mit dem Eingang einer Stromspiegelschaltung (M4) verbunden ist, deren Ausgang parallel mit einem Eingang der ersten Stromspiegelschaltung (M2) verbunden ist.

5. Regelschaltung nach Anspruch 3, dadurch gekennzeichnet, dass die den Polarisationsstrom an die Differentialstufe (D) liefernde Stromspiegelschaltung (M3) durch einen zweiten Ausgang (T7) der ersten Stromspiegelschaltung (M2) gesteuert wird, wobei der erste Ausgang (T4) dieser ersten Spiegelschaltung derjenige ist, der mit dem Ausgang der anderen (M1) der beiden Stromspiegelschaltungen der Ausgangsstufe verbunden ist.

## Claims

1. A device for the regulation of the common mode voltage at the output of a balanced amplifier having two differential outputs (P, Ps), comprising a differential stage (D) providing a correction signal of said common mode voltage corresponding to the difference between an average value (VCM) of the voltages at the differential outputs and a reference voltage (VCM₀), and a current generator setting the polarization current of the differential stage, wherein the current generator is a generator (M3) controlled by the output current of the balanced amplifier.

2. The regulation device of claim 1, wherein the balanced amplifier includes two output stages, each comprising two current mirrors (M1, M2) having an opposite polarity and whose outputs are interconnected, and wherein said differential stage (D) provides an additional correction current, having an appropriate polarity, to the input current of a first (M2) of said two current mirrors.

3. The regulation device of claim 2, wherein the current generator setting the polarization current of said differential stage (D) includes a current mirror (M3) that duplicates, possibly with a multiplying factor (k), the output current of said first current mirror (M2).

4. The regulation device of claim 2, wherein the differential stage (D) includes an output branch that is connected to the input of a current mirror (M4) having its output parallel-connected to the input of the first current mirror (M2).

5. The regulation device of claim 3, wherein the current mirror (M3) providing the polarization current to the differential stage (D) is controlled by a second output (T7) of the first current mirror (M2), the first output (T4) of said first current mirror being the output that is connected to the output of the second (M1) current mirror of the output stage.
